# EUROPÄISCHE PATENTSCHRIFT

(11) **EP 1 477 833 B1**
(45) Veröffentlichungstag und Bekanntmachung des Hinweises auf die Patenterteilung: **13.09.2006**
(21) Anmeldenummer: 04090159.7
(22) Anmeldetag: 22.04.2004
(51) Int. Cl.: G02B 6/42

(54) **Optoelektronische Sende- und/oder Empfangsanordnung**
Opto-electronic transmitting and/or receiving arrangement
Dispositif optoélectronique émetteur et/ou récepteur

(30) Priorität: 29.04.2003 DE 10319900
(43) Veröffentlichungstag der Anmeldung: 17.11.2004
(73) Patentinhaber: Infineon Technologies AG, 81669 München (DE)
(72) Erfinder: Hurt, Hans, 93049 Regensburg (DE); Killer, Thomas, 93155 Hohenschambach (DE); Wittl, Josef, 92331 Parsberg (DE)
(74) Vertreter: Müller, Wolfram Hubertus

(56) Entgegenhaltungen:
- EP-A- 1 170 609
- US-A- 6 021 238
- US-A- 6 071 016
- US-A1- 2002 017 714
- US-A1- 2003 077 053
- "10 GBIT/S OPTICAL FRONT END USING SI-BIPOLAR PREAMPLIFIER IC, FLIPCHIP APD, AND SLANT-END FIBRE" ELECTRONICS LETTERS, IEE STEVENAGE, GB, Bd. 27, Nr. 18, 29. August 1991 (1991-08-29), Seiten 1602-1605, XP000264465 ISSN: 0013-5194

## Beschreibung

Die Erfindung betrifft eine optoelektronische Sende- und/oder Empfangsanordnung gemäß dem Oberbegriff des Anspruchs 1. Sie ermöglicht insbesondere eine elektrische Kontaktierung eines oberflächenmontierbaren optoelektronischen Chips und eine gleichzeitige optische Kopplung des Chips mit einer Lichtleitfaser wie einer POF-(Plastic Optical Fiber) Faser.

Aus der DE 199 09 242 A1 ist ein opto-elektronisches Modul bekannt, bei dem ein Leadframe mit einem opto-elektronischen Wandler in einem Modulgehäuse positioniert und mit einem lichtdurchlässigen, formbaren Material vergossen wird. Eine Lichtein- oder Auskopplung erfolgt über eine Lichtleitfaser, die an einem Stutzen des Modulgehäuses angekoppelt wird. Auf dem Leadframe befindet sich auch der Treiberbaustein bzw. Empfangsbaustein für den opto-elektronischen Wandler.

Des Weiteren sind opto-elektronische Sende- und Empfangsanordnungen bekannt, bei denen die elektro-optischen bzw. opto-elektronischen Wandler sowie die zugehörigen Beschaltungsbausteine (Treiberbaustein bzw. Empfangsverstärkerbaustein) auf einer Transceiver-Platine montiert sind. Die einzelnen Platinen können dabei im engen Abstand zueinander in einem Rack angeordnet werden. Eine Lichtleitfaser wird parallel zu der Transceiver-Platine angekoppelt. Hierzu werden die Kontaktbeine des jeweiligen Wandlerbausteins um 90° gebogen und beispielsweise in THT - (Through Hole Technology) Technologie auf der Transceiver-Platine montiert.

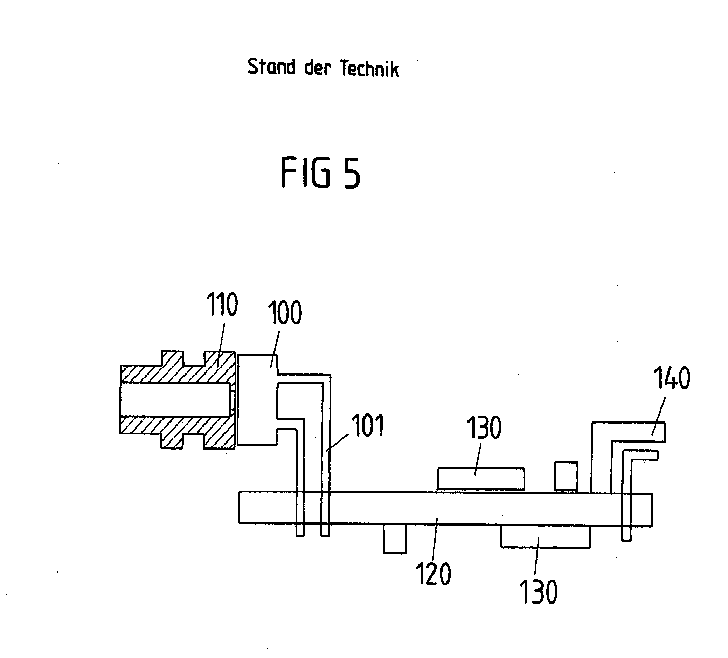

Eine entsprechende Anordnung gemäß dem Stand der Technik ist in der Figur 5 dargestellt. Auf einer Platine 120 sind eine optische Einheit 100 sowie zugehörige aktive und/oder passive elektrische Komponenten 130 angeordnet. Bei der optischen Einheit 100 handelt es sich um einen elektrisch-optischen bzw. optisch-elektrischen Wandler wie eine Laserdiode, eine Fotodiode oder eine LED. Zur Ankopplung einer Lichtleitfaser ist eine Steckeraufnahme 110 vorgesehen, die in paralleler Ausrichtung zu der Platine 120 angeordnet ist, so dass ein Lichtwellenleiter parallel zu der Platine 120 eingesteckt wird. Die optische Einheit 100 empfängt bzw. sendet Licht ebenfalls in einer Richtung parallel zur Platine 120, so dass eine unmittelbare Kopplung mit einem in die Steckeraufnahme 110 eingesetzten Lichtwellenleiter erfolgen kann.

Die Anschlussbeinchen (Leads) 101 der optischen Einheit 100 sind um 90° gebogen und beispielsweise in THT-Technologie auf der Leiterplatte 120 montiert. Des Weiteren dargestellt in Figur 5 ist eine Schnittstelle 140 für hochfrequente elektrische Signale.

In bekannten Modifikationen des in Figur 5 dargestellten Standes der Technik erfolgt die Kontaktierung der optischen Einheit 100 mit der Transceiver-Platine 120 mittels eines Flexboards, das heißt mittels einer flexiblen Struktur, die strukturierte Leiterbahnen enthält. Das Flexboard ist zum einen elektrisch mit der optischen Einheit 100 und zum anderen elektrisch mit der Platine 120 verbunden. In einer weiteren Ausgestaltung wird die optische Einheit 100 in einer Richtung parallel zur Platinenebene unmittelbar auf diese aufgelötet.

Es besteht ein Bedarf nach opto-elektronischen Sende- und/oder Empfangsanordnungen, bei denen die Sendebauelemente bzw. Empfangsbauelemente in oberflächenmontierbaren Bauteilen (SMD - Surface Mounted Device) angeordnet und dementsprechend in einfacher Weise unter Einsatz der Standards der SMD-Technologie auf einer Leiterplatte montiert werden können. Die bekannten Anordnungen sind hierfür nicht geeignet.

Bei Anordnung der opto-elektronischen Bauelemente in SMD-Bauteilen ist zu beachten, dass die optischen Achsen typischerweise senkrecht oder annähernd senkrecht zur Bauteilebene angeordnet sind. Bei Anordnung eines SMD-Bauteils auf einer Transceiver-Platine besteht daher das Problem, entweder den Strahlengang einer parallel zur Platine angekoppelten Lichtleitfaser um 90° umzulenken oder mittels einer Hilfskonstruktion das Bauteil um 90° zu drehen.

Des Weiteren ist bei Lösungen mit SMD-Bauteilen zu beachten, dass das genaue Fügen des Receptacle einen erheblichen Kostenfaktor darstellt. Da ein Receptacle je nach Ausführung auch mechanische Kräfte ganz oder teilweise übertragen muss, ist eine solide mechanische Verankerung des Receptacles im Gehäuse oder in der Hauptschaltungsplatine (Motherboard) erforderlich. Dabei ist sicherzustellen, dass auftretende mechanische Kräfte nicht die optische Kopplung zwischen optischer Einheit und Receptacle beeinflussen oder gar zerstören.

In der US-A-6 071 016 wird eine opto-elektronische Anordnung mit einer Kopplungseinheit und einer Fotodetektor-Einheit beschrieben, wobei beide Einheiten als gesonderte Einheiten ausgebildet sind. Die Fotodetektor-Einheit weist eine keramische Leiterplatte mit einer Fotodiode auf, die zur Kontaktierung des Schaltungsträgers verwendet wird.

In der US-A-6 021 238 wird eine gattungsgemäße opto-elektronische Anordnung beschrieben, bei der auf einem Trägersubstrat ein Sendeelement, ein Empfangselement und ein Monitorelement angeordnet sind. Die elektrischen Kontakte dieser optischen Elemente sind durch Metallisierung auf der dem Leadframe abgewandten Seite des Substrats ausgebildet. Die Kontaktierung dieser Metallisierungen erfolgt über Bondverbindungen zu den jeweiligen Leads des Leadframes. Die Trägerfläche des Leadframes dient lediglich der mechanischen Aufnahme des Trägersubstrats.

Ausgehend von dem genannten Stand der Technik liegt der vorliegenden Erfindung die Aufgabe zu Grunde, eine opto-elektronische Sende- und/oder Empfangsanordnung zur Verfügung zu stellen, die auch bei einer Verwendung von SMD-Bauteilen für die opto-elektronischen und elektrischen Komponenten eine sichere Ankopplung eines Lichtwellenleiters ermöglicht und sich dabei durch einen kompakten und kostengünstigen Aufbau auszeichnet.

Diese Aufgabe wird erfindungsgemäß durch eine opto-elektronische Sende- und/oder Empfangsanordnung mit den Merkmalen des Anspruchs 1 gelöst. Bevorzugte und vorteilhafte Ausgestaltungen der Erfindung sind in den Unteransprüchen angegeben.

Die erfindungsgemäße Lösung geht davon aus, dass ein Kopplungsteil zur Aufnahme und Ankopplung einer Lichtleitfaser ein Leadframe aufweist, das erste Kontaktbereiche zum Kontaktieren des Schaltungsträgers und zweite Kontaktbereiche zum Kontaktieren einer Hauptschaltungsplatine aufweist. Erfindungsgemäß erfolgt die elektrische Kontaktierung des Schaltungsträgers über das Leadframe und ist die optische Einheit als oberflächenmontierbarer Chip ausgebildet, der auf das Kopplungsteil aufsetzbar ist, wobei die elektrischen Kontakte des Chips mit den zugehörigen ersten Kontaktbereichen des Leadframes direkt verbunden sind.

Die erfindungsgemäße Lösung beruht somit auf dem Gedanken, die Kontaktierung des Schaltungsträgers über die Aufnahme- und Ankoppelstruktur für die Lichtleitfaser vorzunehmen. Hierdurch entsteht ein synergetischer Effekt insofern, als das Kopplungsteil neben der mechanischen Aufnahme und Positionierung einer Lichtleitfaser auch einer Stromführung dient. Darüber hinaus kann über das Kopplungsteil in effektiver Weise Wärme vom Schaltungsträger weggeführt werden, die in den opto-elektronischen und elektrischen Bauelementen entsteht.

Die erfindungsgemäße Lösung ist insofern besonders kompakt, als die optische Einheit mit dem Schaltungsträger, dem opto-elektronischen Bauelement und dem elektrischen Beschaltungsbauelement lediglich auf das Kopplungsteil zur Aufnahme einer Lichtleitfaser aufgesetzt werden muss. Die elektrische Kontaktierung und mechanische Stabilisierung der Anordnung erfolgt dann über das Kopplungsteil. Eine gesonderte Hilfskonstruktionen zur Befestigung und Anordnung der optischen Einheit ist nicht erforderlich.

Die erfindungsgemäße Lösung eignet sich insbesondere für Ausgestaltungen, bei der die optische Einheit als SMD-Bauteil realisiert ist. Das SMD-Bauteil wird dabei direkt auf eine Oberfläche des Kopplungsteils aufgesetzt, die hierfür geeignete elektrische Kontakte aufweist.

Zur Herstellung eines Kopplungsteils mit einem Leadframe wird bevorzugt ein planes Leadframe in geeigneter Weise geätzt oder gestanzt und dann in einen Polymerkörper eingebettet, der das eigentliche Aufnahme- und Kopplungsteil für eine optische Lichtleitfaser darstellt. Zur Befestigung des Leadframes des Kopplungsteils auf der Hauptschaltungsplatine bestehen zwei bevorzugte Möglichkeiten. In der einen Alternative wird das Leadframe um 90° bebogen, wobei es zum einen als Lötfläche für die optische Einheit und zum anderen als Lötfläche für die Hauptschaltungsplatine dient. Das Kopplungsteil ist dann ebenfalls als SMD-Bauteil ausgebildet. Alternativ kann das Kopplungsteil auch in THT- Technologie auf dem Hauptschaltungsträger befestigt werden, wobei die einzelnen Kontaktbeinchen durch geeignete Löcher in der Hauptschaltungsplatine durchgeführt werden. Bei dieser Variante wird das Leadframe nach dem Umspritzen mit Kunststoff nicht um 90° gebogen.

In einer bevorzugten Ausgestaltung der Erfindung weist der Schaltungsträger mindestens eine Öffnung auf. Das Sendebauelement bzw. Empfangsbauelement wird dabei derart auf der einen Seite des Schaltungsträgers angeordnet, dass der optische Pfad von und zu dem Sende- und/oder Empfangsbauelement durch die Öffnung hindurch zur anderen Seite des Schaltungsträgers verläuft. Diese andere Seite ist dabei die Rückseite, das heißt eine Lichtein- und auskopplung erfolgt rückseitig. Die Rückseite des Schaltungsträgers ist dabei mit dem Kopplungsteil verbunden, so dass das ein- oder ausgekoppelte Licht unmittelbar mit einer in ein Kopplungsteil eingesteckten Lichtleitfaser koppelbar ist.

In einer weiteren vorteilhaften Ausgestaltung der Erfindung sind sowohl an dem Kopplungsteil als auch an dem Schaltungsträger Justagestrukturen vorgesehen, die eine passive Ausrichtung von optischer Einheit und Kopplungsteil ermöglichen. Dies kann auf vielfältige Weise erfolgen. Beispielsweise werden im Schaltungsträger etwa mittels einer Halfetch-Technik Vertiefungen erzeugt, die mit entsprechenden Gegenstrukturen im Kopplungsteil korrespondieren. Das Kopplungsteil weist dann an seiner der optischen Einheit zugewandten Seite Vorsprünge auf, die mit Vertiefungen wie einer Nut oder einem Loch an der Rückseite der optischen Einheit korrespondieren. Natürlich können geeignete Vertiefungen auch im Kopplungsteil und Vorsprünge an der optischen Einheit ausgebildet sein.

In einer besonders bevorzugten Ausgestaltung befindet sich in der Öffnung des Schaltungsträger zur Bereitstellung eines optischen Pfads eine optische Linse. Die optische Linse steht dabei über der Rückseite des Schaltungsträgers hervor und bewirkt eine mechanische Kopplung des Schaltungsträgers mit dem Kopplungsteil sowie eine gleichzeitige gegenseitige Justage. Die optische Linse besitzt somit neben ihrer lichtformenden Funktion eine Justagefunktion. Die Linse ist dabei so geformt, dass sie sich in der Öffnung des Schaltungsträgers selbst zentriert. In der der dem Schaltungsträger zugewandten Seite des Kopplungsteils befindet sich dabei ebenfalls eine Öffnung bzw. ein Loch, in dem die Linse selbsttätig mechanisch zentriert wird, wenn die optische Einheit auf das Kopplungsteil gesetzt wird. Auf diese Weise wird eine kostengünstige und genaue Justage der optischen Achsen der optischen Einheit und des Kopplungsteils bereitgestellt.

Der Schaltungsträger der optischen Einheit ist bevorzugt als segmentierte Grundplatte ausgebildet, deren einzelne Segmente ein unterschiedliches Potential aufweisen können. Die Segmentierung des Schaltungsträger bzw. der Grundplatte führt zu einer Auftrennung und elektrischen Segmentierung der Grundplatte in einzelne "Inseln". Dadurch wird ein erhöhtes Maß an Flexibilität für die Schaltungsanordnung geschaffen.
Die einzelnen "Inseln" bzw. Segmente können als Kontaktflächen der Schaltung dienen, da jede "Insel" bzw. jedes Segment ein für die Schaltung notwendiges Potential tragen kann.

In einer bevorzugten Weiterbildung dieser Ausgestaltung weist das Leadframe des Kopplungsteils eine der Segmentierung des Schaltungsträgers entsprechende Segmentierung auf. Hierdurch wird eine besonders effektive Wärmeabführung auf das Kopplungsteil erreicht. Das Leadframe des Kopplungsteils ist dabei bevorzugt ein relativ dick ausgebildetes Metall mit einer Dicke von bevorzugt größer gleich 0,2 mm, besonders bevorzugt größer gleich 0,3 mm, so dass die in der optischen Einheit erzeugte Verlustwärme effektiv aufgenommen und an die Hauptschaltungsplatine abgegeben werden kann. Die auf einem Segment des Schaltungsträgers der optischen Einheit durch ein auf dem entsprechenden Segment angeordnetes Bauteil erzeugte Wärme koppelt dabei durch die Rückseite des Schaltungsträgers hindurch auf das Leadframe des Kopplungsteils und wird von diesem an die Hauptschaltungsplatine weitergegeben. Je dicker das Metall des Leadframes dabei ist, desto höher die Wärmekapazität des Leadframes und die Wärmeableitung zur Hauptschaltungsplatine.

Durch das Leadframe des Kopplungsteils lässt sich eine geeignete Anpassung des Pitches (Raster der Kontaktbeinchen) an die jeweiligen Erfordernisse erreichen ("Foot Print"). Beispielsweise werden breite Leads bzw. Kontaktbeinchen für einen besseren Wärmetransport verwendet.

Zur Befestigung des Kopplungsteils auf der Hauptsschaltungsplatine ist in dieses bevorzugt eine mechanische Verankerungsstruktur integriert, die auch den Platzierungsvorgang erleichtert. Beispielsweise ragt aus dem Kopplungsteil in Richtung der Hauptschaltungsplatine ein Zapfen hervor, der in eine entsprechende Öffnung der Hauptschaltungsplatine gleiten kann.

In einer weiteren bevorzugten Ausgestaltung ist vorgesehen, dass eine optische Einheit mit einem Sendebauelement und eine optische Einheit und einem Empfangsbauelement in einem gemeinsamen Umgehäuse angeordnet sind, das bevorzugt ebenfalls das Kopplungsteil mit umgibt. Eine optische Sendeeinheit und eine optische Empfangseinheit können mittels einen solchen Umgehäuses zu einem Transceiver zusammengeführt werden.

Das gemeinsame Umgehäuse kann aus einem Kunststoff bestehen, eine Sandwichstruktur mit einem Kunststoff und einem elektrisch leitenden Material besitzen oder auch ausschließlich aus einem metallischen Material bestehen. Bevorzugt besteht das Umgehäuse aus einem elektrischmagnetisch abschirmenden Material oder weist ein solches auf, so dass das Umgehäuse gleichzeitig als EMV-Schild dient und somit die optische Einheit einschließlich ihrer Anschlusskontakte in einer Art Farradyschen Käfig geschirmt angeordnet ist. Lediglich zur Hauptschaltungsplatine und zur optischen Faser besteht eine Öffnung im Umgehäuse.

Das Umgehäuse kann auch mehr als zwei Kavitäten aufweisen, so dass eine Vielzahl von optischen Einheiten mit Sendebauelementen und/oder Empfangsbauelementen in einem gemeinsamen Umgehäuse angeordnet werden können, beispielsweise wenn mehrere Sendebauelemente in einem Array angeordnet sind.

Durch entsprechend robuste Auslegung des Umgehäuses ist es möglich, das Umgehäuse zur Aufnahme mechanischer Kräfte beim Ein- und Ausstecken eines optischen Steckers in das Kopplungsteil zu nutzen. Bei einer solchen Ausgestaltung ist das Umgehäuse mit dem Kopplungsteil bevorzugt verklebt.

Zum Bereitstellen eines definierten Potentials des Umgehäuses weist dieses eine Masse-Verbindung auf, die beispielsweise über Kontaktpins des Kopplungsteils oder alternativ über eigene Stifte oder SMD-Kontakte bereitgestellt wird.

Ein weiterer Vorteil der Verwendung eines Umgehäuses besteht darin, dass dieses selbst dann sinnvoll einsetzbar ist, wenn es lediglich auf die optische Einheit und das Kopplungsteil aufgesteckt, nicht jedoch geklebt wird. Bei einem Löten des Transceivers beim Kunden wird die optische Einheit bzw. der SMD-Chip durch die genannten passiven Justagestrukturen in seiner Position zum Kopplungsteil fixiert, auch bei einem Aufschmelzen der Lotverdingung von SMD-Chip zu Kopplungsteil.

Das Kopplungsteil weist eine grundsätzlich beliebig ausgestaltete Aufnahme- und Koppelöffnung für eine anzukoppelnde optische Lichtleitfaser auf. Bevorzugt ist dabei eine Struktur vorgesehen, die der rastenden Aufnahme eines optischen Steckers dient. Dies kann beispielsweise durch eine an sich bekannte Bajonettverankerung erfolgen. Grundsätzlich kann jedoch auch vorgesehen sein, dass statt eines lösbaren optischen Steckers eine optische Stummelfaser fest in dem Kopplungsteil angeordnet wird. Die im Kopplungsteil fest installierte Faser weist dabei an ihrem aus dem Kopplungsteil herausragenden Ende eine Schnittstelle zu einer optischen Lichtleitfaser auf (sogenannten Pigtail-Lösung) .

Die Erfindung wird nachfolgend unter Bezugnahme auf die Figuren der Zeichnungen anhand näherer Ausführungsbeispiele näher erläutert. Es zeigen:
- Fig. 1a: einen SMD-Chip mit einem Sendebauelement, einem Treiberbaustein und einer in einer Öffnung eines Schaltungsträger angeordneten Linse;
- Fig. 1b: eine Seitenansicht des SMD-Chips der Figur 1a;
- Fig. 2a: eine Draufsicht auf die Stirnseite eines mit einem SMD-Chip gemäß den Figuren 1a, 1b zu koppelnden Kopplungsteils zur Aufnahme und Ankopplung einer Lichtleitfaser;
- Fig. 2b: eine seitliche Schnittansicht des Kopplungsteils der Figur 2a;
- Fig. 3a: die Anordnung eines SMD-Chips gemäß den Figuren 1a, 1b auf der Stirnseite eines Kopplungsteils gemäß den Figuren 2a, 2b in Draufsicht;
- Fig. 3b: eine seitliche Schnittansicht der Anordnung der Figur 3a;
- Fig. 4a: einen Transceiver mit einem SMD-Chip mit einem Sendebauelement und einem SMD-Chip mit einem Empfangsbaulement in einem gemeinsamen Umgehäuse in Draufsicht;
- Fig. 4b: eine seitliche Schnittansicht des Transceivers der Figur 4a und
- Fig. 5: eine opto-elektronische Sende- und/oder Empfangsanordnung gemäß dem Stand der Technik.

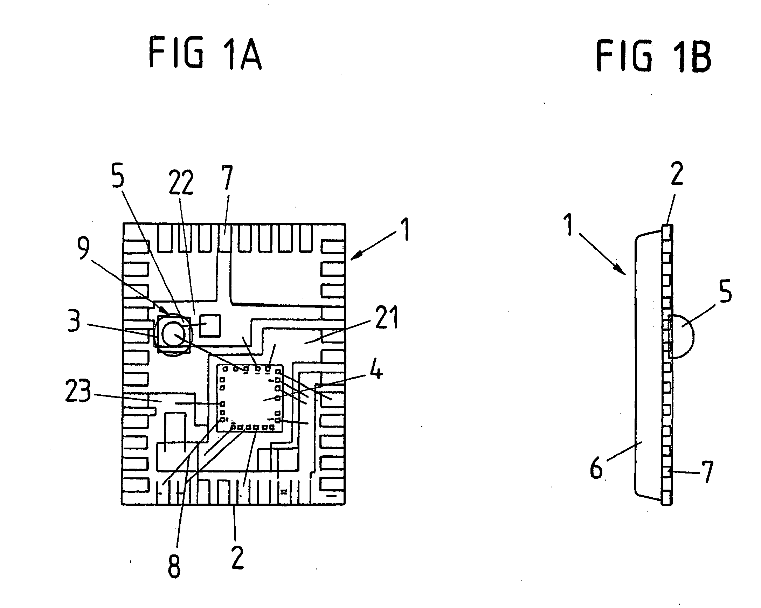

Die Figuren 1a, 1b zeigen eine optische Einheit 1 mit einem Schaltungsträger bzw. einer Grundplatte 2, auf der ein opto-elektronisches Sendebauelement 3 sowie ein zugehöriger Treiberchip 4 angeordnet sind. Das Sendebauelement 3 und der Treiberchip 4 sind in üblicher Weise über Bonddrähte 8 mit Kontaktflächen 7 am Rand des Schaltungsträgers 2 verbunden. Die optische Einheit 1 ist als SMD-Chip ausgebildet und dementsprechend direkt auf der Oberfläche eines weiteren Schaltungsträgers bzw. einer Platine platzierbar und dort im Lötbad kontaktierbar.

Die mit dem Sendebauelement 3 und dem Treiberchip 4 versehene Oberseite des Schaltungsträgers 2 ist von einer optisch nicht transparenten Vergußmasse 6 vollständig umhüllt, die gleichzeitig ein Gehäuse des Chips 1 bereitstellt.

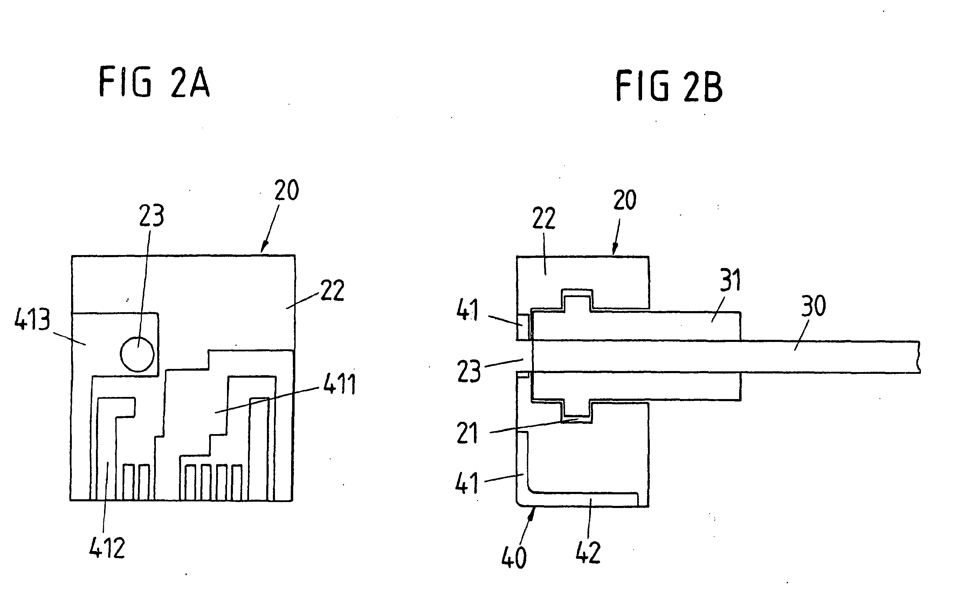

In dem Schaltungsträger 2 befindet sich im Bereich des Sendebauelementes 5 eine Öffnung 9, in die eine gegenüber der Rückseite des Schaltungsträgers 2 hervorstehende optische Linse 5 eingesetzt ist. Durch die Öffnung 9 in dem Schaltungsträger 2 wird ein optischer Pfad zur Rückseite des Schaltungsträgers 2 bereitgestellt und damit die Möglichkeit einer rückseitigen Kopplung mit einem Lichtwellenleiter geschaffen, der in einem in den Figuren 2a, 2b dargestellten Kopplungsteil angeordnet ist. Im Bereich der Öffnung 9 des Schaltungsträger 2 befindet sich keine Vergußmasse 6.

Die Grundplatte (das "diepad") bzw. der Schaltungsträger 2 weist im dargestellten Ausführungsbeispiel, jedoch nicht notwendigerweise eine Segmentierung auf, durch die in der Grundplatte elektrisch getrennte Inseln entstehen, die als Kontaktflächen der Schaltung dienen und jeweils ein für die Schaltung notwendiges Potential tragen können. In Figur 1a sind beispielsweise Inseln bzw. Segmente 21, 22, 23 erkennbar. Die Grundplatte 2 wird dabei als Teil der Schaltung genutzt.

Der SMD-Chip 1 der Figuren 1a, 1b ist lediglich beispielhaft zu verstehen. Grundsätzlich können SMD-Chips in beliebiger Bauart und Bauform eingesetzt werden. Von Bedeutung ist allein, dass auf dem SMD-Chip sowohl ein opto-elektronischer Wandler als auch ein zugehöriger Beschaltungsbaustein angeordnet sind. Die Lichtein- und -auskopplung in den Chip erfolgt bevorzugt rückseitig durch eine Öffnung in der Grundplatte 2.

In entsprechende Weise wie Figur 1a, 1b kann die optische Einheit 1 auch als Empfangs-SMD-Chip ausgebildet sein. Statt eines Sendebauelementes wird dabei ein Empfangsbauelement verwendet. Statt eines Wandlerchips ist als Beschaltungselement ein Empfangsverstärkerchip vorgesehen. Auch bei der Ausbildung der optischen Einheit als Empfangseinheit ist bevorzugt eine optische Linse 5 vorgesehen, die in eine Öffnung des Schaltungsträgers eingesetzt ist und dabei gegenüber der Rückseite des Schaltungsträgers hervorsteht, um wie nachfolgend noch beschrieben eine mechanische Kopplung und Justage mit einem Kopplungsteil herbeizuführen.

Die Figuren 2a, 2b zeigen ein Kopplungsteil 20, dass zunächst der Aufnahme und Ankopplung einer Lichtleitfaser 30 dient. Die Lichtleitfaser 30 ist dabei beispielsweise über einen schematisch dargestellten optischen Stecker 31 steckbar in einer Aufnahmeöffnung 21 des Kopplungsteils 20 angeordnet. Das Kopplungsteil 20 kann grundsätzlich ein beliebiges mechanisches Gebilde sein, dass einen Anschluss einer Lichtleitfaser ermöglicht. Die dargestellten Ausführungsformen sind lediglich beispielhaft zu verstehen. Das Kopplungsteil kann auch als Receptacle bzw. als Steckeraufnahme bezeichnet werden.

Das Kopplungsteil 20 ist beispielsweise als Spritzgussteil ausgebildet und weist einen Polymerkörper 22 auf. In dem Polymerkörper ist stirnseitig ein Leadframe 40 eingebettet, dass im dargestellten Ausführungsbeispiel einen ersten Kontaktbereich 41 zur Ankopplung des SMD-Chips der Figuren 1a, 1b und zum anderen einen zweiten Kontaktbereich 42 zur Anordnung des Kopplungsteils auf einer Hauptschaltungsplatine (Motherboard) aufweist. Herstellungstechnisch wird dabei zunächst ein planes Leadframe verwendet und dieses dann um 90° gebogen. Hierdurch ist auch das Kopplungsteil 20 als SMD-Bauteil ausgeführt.

Das Leadframe 40 ist in seinem dem SMD-Chip 1 zugewandten Bereich 41 ebenfalls segmentiert, und zwar unter Ausbildung von Segmenten, die in ihrer Geometrie im Wesentlichen der Geometrie oder zumindest dem Ort der Segmente 21, 22, 23 der Grundplatte 2 des SMD-Chips 1 entsprechen, vgl. Figuren 1a, 1b. Die Figur 2a zeigt drei solcher Segmente 411, 412, 413. Die entsprechenden Segmente dienen der Aufnahme und Ableitung von Wärme, die auf der Schaltungsplatine 2 des SMD-Chips durch dort vorhandene Bausteine 3, 4 erzeugt wird. Die entsprechenden Bausteine 3, 4 bzw. Segmente 21, 22 des SMD-Chips 1 werden rückseitig durch die entsprechenden Segmente 411, 413 des Leadframes 14 des Kopplungsteils 20 gekühlt. Die durch den Kontaktbereich 41 aufgenommene Wärme wird über den Kontaktbereich 42 des Leadframes 40 an die Hauptschaltungsplatine abgeleitet.

Auf diese Weise erfolgt eine sehr effektive Kühlung der Bausteine 3, 4 des SMD-Chips 1. Durch die auf Grund der Segmentierung erfolgte thermische Trennung können dabei Temperaturanforderungen leichter erfüllt werden. Die lokal entstehende Energie kann gezielt über vorgegebene Wärmepfade durch die Grundplatte 2 hindurch abtransportiert werden.

Es wird darauf hingewiesen, dass der Kontaktbereich 42 zur Hauptschaltungsplatine statt in SMD-Ausführung beispielsweise auch in THT-Technologie aufgeführt werden kann, wobei die Beine des Leadframes nicht gebogen und durch Löcher der Hauptschaltungsplatine gesteckt werden (Pin Through Hole).

Im Kopplungsteil 20 befindet sich eine Aussparung 23, die der Aufnahme einer vom SMD-Chip vorstehenden Struktur dient. Bei einer solchen vorstehenden Struktur, die eine passive Justage von SMD-Chip 1 und Kopplungsteil 20 ermöglicht, handelt es sich insbesondere um die Linse 5 der Figur 1a, 1b, die genau in die Öffnung 23 des Kopplungsteils passt und sich dort selbsttätig mechanisch zentriert, wenn der SMD-Chip 1 auf das Receptacle 20 gesetzt wird.

Statt einer Linse kann eine mechanische Zentrierung und Justage auch durch andere passive Strukturen am SMD-Chip 1 und am Kopplungsteil 20 erfolgen. Es sind dabei jeweils miteinander korrespondierende Gegenstrukturen zu verwenden.

Bei der in das Kopplungsteil 20 eingeführten Lichtleitfaser 30 handelt es sich bevorzugt um POF- (Plastic Optical Fibre) Faser. Dementsprechend ist das Sendebauelement 3 der Figur 1a, 1b bevorzugt eine Leuchtdiode. Grundsätzlich ist die beschriebene Anordnung jedoch ebenso für Glasfasern und Multi- oder Singlemode-Komponenten einsetzbar. Dabei ergeben sich keine grundsätzlichen Änderungen.

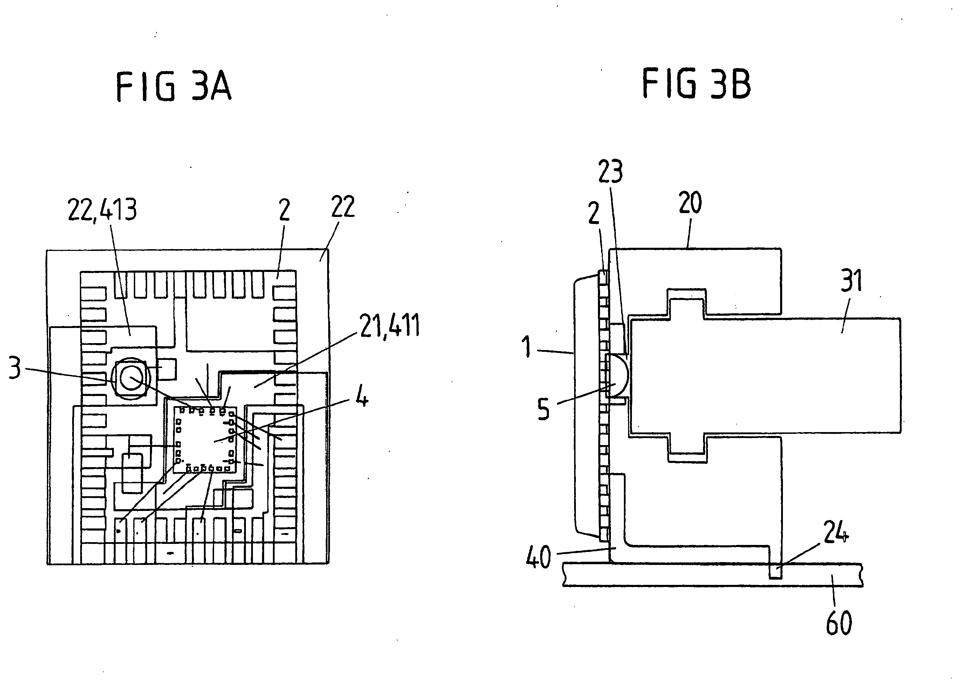

Die Figuren 3a, 3b zeigen den auf des Kopplungsteil 20 aufmontierten SMD-Chip 1. Eine Ausrichtung der beiden Teile 1, 20 erfolgt über die Koppellinse 5, die rückseitig gegenüber der Trägerplatte 2 des SMD-Chips 1 hervorsteht und in die Aussparung 23 des Kopplungsteils 20 ragt. Auf diese Weise werden automatisch die optischen Achsen des Sendebauelementes 3 und der Lichtleitfaser 30 genau aufeinander ausgerichtet. Über die optische Linse 5 wird das vom Sendebauelement 3 ausgestrahlte Licht dabei genau auf die Stirnfläche der Lichtleitfaser 30 abgebildet.

In der Figur 3a ist gut zu erkennen, dass die Segmentierungen 21, 22 der Trägerplatte 2 des SMD-Chips 1 und die Segmentierungen 411, 413 des Leadframes 40 des Kopplungsteils 20 einander im Wesentlichen entsprechen, so dass von dem Sendebauelement 3 und dem Treiberchip 4 erzeugte Wärme gezielt und thermisch getrennt abgeleitet werden kann.

Zu einer verbesserten mechanischen Befestigung des Receptacles 20 auf der Hauptschaltungsplatine und/oder zur Erleichterung des Platzierungsvorgangs der Komponente 20 auf einer (schematisch dargestellten) Hauptschaltungplatine 60 kann in den Körper des Receptacles 20 eine mechanische Verankerungsstruktur integriert sein, beispielsweise ein vorstehender Zapfen 24, der mit einer Aussparung der Hauptschaltungsplatine 60 korrespondiert.

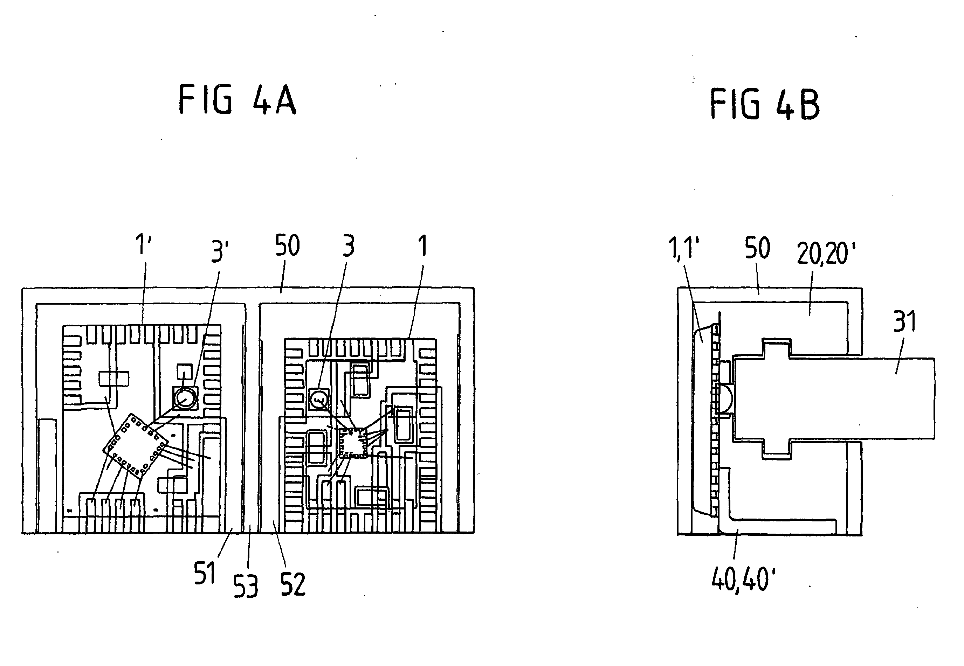

Die Figuren 4a, 4b zeigen ein Ausführungsbeispiel, bei dem eine optische Einheit 1 mit einem Sendebauelement 3 und eine optische Einheit 1' mit einem Empfangsbauelement 3' nebeneinander angeordnet sind und einen Transceiver bilden. Es sind zugehörige Kopplungsteile 20, 20' mit Leadframes 40, 40' vorgesehen. Die einzelnen optischen Einheiten 1, 1' sind mittels eines Umgehäuses 50 bzw. einer Haube 50 miteinander verbunden, die zwei Kavitäten aufweist.

Die Haube 50 besteht bevorzugt aus einem metallischen Material oder weist ein solches auf, so dass die Haube 50 leitfähig ist und als EMV-Schild dient. Wie der Figur 4b zu entnehmen ist, besteht lediglich nach unten (zur Hauptschaltungsplatine) und seitlich (für die anzukoppelnde Faser) eine Öffnung in der Haube 50. Die Haube 50 weist dabei bevorzugt auch eine gewisse mechanische Stabilität auf, so dass sie beim Stecken eines optischen Steckers 31 auftretende Steckkräfte aufnehmen kann. Dabei ist die Haube 50 bevorzugt mit Kopplungsteil 20, 20' verklebt.

Eine Groundverbindung der Haube 50 lässt sich über Kontaktpins des Kopplungsteils 20, 20' oder alternativ durch gesonderte Stifte oder SMD-Kontakte der Haube 50 herstellen.

Die Haube 50 weist zwischen ihren beiden Kavitäten 51, 52 eine die beiden optischen Einheiten 1, 1' und zugehörigen Kopplungsteile 20, 22' trennende Mittelwand 53 auf, die die Sende- und Empfangskomponenten voneinander abschirmt.

Das Kopplungsteil 20 der Sendeeinheite und das Kopplungsteil 20' der Empfangseinheit können als ein Teil (natürlich mit zwei gesonderten Leadframes) gespritzt werden. Dabei kann vorgesehen sein, eine Verbindungsbrücke bzw. einen Verbindungssteg zwischen beiden Teilen 20, 20' stehen zu lassen, bevorzugt an der unteren Kante und mit einer Dicke von zum Beispiel 1 mm.

Die Erfindung beschränkt sich in ihrer Ausgestaltung nicht auf die vorstehend dargestellten Ausführungsbeispiele. Beispielsweise kann ebenso vorgesehen sein, dass auf einem Chip sowohl ein Sendebauelement als auch ein Empfangsbauelement und die jeweils zugehörigen Beschaltungsbausteine angeordnet sind, wobei das ausgesandte bzw. empfangende Licht in eine Lichtleitfaser ein- bzw. ausgekoppelt wird. Dabei wird ein Übersprechen zwischen Eingangs- und Ausgangskanal beispielsweise durch die Verwendung von Licht unterschiedlicher Wellenlängen und die Verwendung optische Filter auf dem Chip verhindert.

## Patentansprüche

1. Optoelektronische Sende- und/oder Empfangsanordnung mit
- einer optischen Einheit (1, 1') aufweisend:
o ein Sendebauelement (3) und/oder ein Empfangsbauelement (3'),
o ein elektrisches Beschaltungsbaulement (4) für das Sendebauelement (3) und/oder das Empfangsbauelement (3'),
o einen Schaltungsträger (2), auf dem die Bauelemente (3, 3', 4) montiert und elektrisch kontaktiert sind, und
- einem Kopplungsteil (20, 20') zur Aufnahme und Ankopplung mindestens einer optischen Lichtleitfaser (30), die optisch mit dem Sendebauelement (3) und/oder dem Empfangsbauelement (3') koppelbar ist, wobei das Kopplungsteil (20) ein Leadframe (40) aufweist, das erste Kontaktbereiche (41) zum elektrischen Kontaktieren des Schaltungsträgers (2) und zweite Kontaktbereiche (42) zum elektrischen Kontaktieren einer Hauptschaltungsplatine (60) aufweist,
**dadurch gekennzeichnet, dass**
- die elektrische Kontaktierung des Schaltungsträgers (2) über das Leadframe (40) erfolgt, und
- die optische Einheit (1, 1') als oberflächenmontierbarer Chip ausgebildet ist, der auf das Kopplungsteil (20, 20') aufsetzbar ist,
wobei die elektrischen Kontakte (7) des Chips mit den zugehörigen ersten Kontaktbereichen (41) des Leadframes (40) direkt verbunden sind.

2. Anordnung nach Anspruch 1, **dadurch gekennzeichnet, dass** der Schaltungsträger (2) mindestens eine Öffnung (9) aufweist und das Sendebauelement (3) bzw. Empfangsbauelement (3') derart auf der einen Seite des Schaltungsträgers (2) angeordnet ist, dass der optische Pfad von und zu dem Sende- und/oder Empfangsbauelement (3, 3') durch die Öffnung (9) zur anderen, Rückseite des Schaltungsträgers (2) verläuft, wobei der Schaltungsträger (2) rückseitig mit dem Kopplungsteil (20) gekoppelt ist.

3. Anordnung nach Anspruch 2 oder 3, **dadurch gekennzeichnet, dass** Justagestruktren (23, 5) an dem Kopplungsteil (20) und an dem Schaltungsträger (2) vorgesehen sind, die eine passive Ausrichtung der Teile ermöglichen.

4. Anordnung nach Anspruch 2 und 3, **dadurch gekennzeichnet, dass** in der Öffnung (9) des Schaltungsträgers (2) eine optische Linse (5) angeordnet ist, gegenüber der Rückseite des Schaltungsträgers (2) hervorsteht und eine mechanische Kopplung und Justage des Schaltungsträgers (2) mit dem Kopplungsteil (20) bewirkt.

5. Anordnung nach einem der vorangehenden Ansprüche, **dadurch gekennzeichnet, dass** der Schaltungsträger (2) als eine segmentierte Grundplatte ausgebildet ist, deren einzelne Segmente (21, 22, 23) ein unterschiedliches Potential aufweisen können.

6. Anordnung nach Anspruch 5, **dadurch gekennzeichnet, dass** das Leadframe (40) des Kopplungsteils im Kontaktbereich (41) zum Schaltungsträger (2) ebenfalls segmentiert ist und Segmente (411, 412, 413) aufweist, die denen des Schaltungsträgers (2) entsprechen.

7. Anordnung nach Anspruch 6, **dadurch gekennzeichnet, dass** das Leadframe (40) aus einem relativ dicken Metall, bevorzugt mit einer Dicke größer gleich 0,2 mm, besonders bevorzugt mit einer Dicke größer gleich 0,3 mm gebildet ist.

8. Anordnung nach einem der vorangehendne Ansprüche, **dadurch gekennzeichnet, dass** das Kopplungsteil (20) eine mechanische Verankerungsstruktur (24) zur mechanischen Verbindung mit der Hauptschaltungsplatine (60) aufweist.

9. Anordnung nach einem der vorangehenden Ansprüche, **dadurch gekennzeichnet, dass** das Kopplungsteil (20) als oberflächenmontierbares Teil ausgebildet ist.

10. Anordnung nach einem der vorangehenden Ansprüche, **dadurch gekennzeichnet, dass** mindestens eine optische Einheit (1) mit einem Sendebauelement (3) und eine optische Einheit (1') mit einem Empfangsbauelement (3') in einem gemeinsamen Umgehäuse (50) mit zwei Kavitäten (51, 52) angeordnet sind.

11. Anordnung nach Anspruch 10, **dadurch gekennzeichnet, dass** das Umgehäuse (50) das der jeweiligen optischen Einheit (1, 1') zugehörige Kopplungsteil (20, 20') mit umgibt.

12. Anordnung nach Anspruch 10 oder 11, **dadurch gekennzeichnet, dass** das Umgehäuse (50) aus einem elektromagnetisch abschirmenden Material besteht oder ein solches aufweist.

13. Anordnung nach einem der Ansprüche 10 bis 12, **dadurch gekennzeichnet, dass** das Kopplungsteil (20, 20') für die beiden Schaltungsträger (2) bzw. optischen Einheiten (1, 1') hinsichtlich seiner mechanischen Strukturen einteilig ausgeführt ist, wobei bevorzugt zwei Teilbereiche ausgebildet sind, die durch einen Verbindungssteg miteinander verbunden sind.

## Claims

1. Optoelectronic transmission and/or reception arrangement with
- an optical unit (1, 1') having:
o a transmission component (3) and/or a reception component (3'),
o an electrical circuitry component (4) for the transmission component (3) and/or the reception component (3'),
o a circuit carrier (2), on which the components (3, 3', 4) are mounted and electrically contact-connected, and
- a coupling part (20, 20') for receiving and coupling at least one optical fibre (30) which can be optically coupled to the transmission component (3) and/or the reception component (3'),
the coupling part (20) having a leadframe (40) having first contact regions (41) for electrically contact-connecting the circuit carrier (2) and second contact regions (42) for electrically contact-connecting a main circuit board (60),
**characterized in that**
- the electrical contact-connection of the circuit carrier (2) is effected via the leadframe (40),
- the optical unit (1, 1') is formed as a surface-mountable chip, which can be placed onto the coupling part (20, 20'), the electrical contacts (7) of the chip being directly connected to the associated first contact regions (41) of the leadframe (40) .

2. Arrangement according to Claim 1, **characterized in that** the circuit carrier (2) has at least one opening (9) and the transmission component (3) or reception component (3')respectively is arranged on one side of the circuit carrier (2) in such a way that the optical path from and to the transmission and/or reception component (3, 3') runs through the opening (9) to the other, rear side of the circuit carrier (2), the circuit carrier (2) being coupled to the coupling part (20) on the rear side.

3. Arrangement according to Claim 2 or 3, **characterized in that** provision is made of adjustment structures (23, 5) at the coupling part (20) and at the circuit carrier (2), which enable passive orientation of the parts.

4. Arrangement according to Claims 2 and 3, **characterized in that** an optical lens (5) is arranged in the opening (9) of the circuit carrier (2), projects relative to the rear side of the circuit carrier (2) and effects a mechanical coupling and adjustment of the circuit carrier (2) with the coupling part (20).

5. Arrangement according to one of the preceding claims, **characterized in that** the circuit carrier (2) is formed as a segmented baseplate, the individual segments (21, 22, 23) of which may have a different potential.

6. Arrangement according to Claim 5, **characterized in that** the leadframe (40) of the coupling part is likewise segmented in the contact region (41) with respect to the circuit carrier (2) and has segments (411, 412, 413) corresponding to those of the circuit carrier (2).

7. Arrangement according to Claim 6, **characterized in that** the leadframe (40) is formed from a relatively thick metal, preferably having a thickness of greater than or equal to 0.2 mm, particularly preferably having a thickness of greater than or equal to 0.3 mm.

8. Arrangement according to one of the preceding claims, **characterized in that** the coupling part (20) has a mechanical anchoring structure (24) for mechanical connection to the main circuit board (60) .

9. Arrangement according to one of the preceding claims, **characterized in that** the coupling part (20) is formed as a surface-mountable part.

10. Arrangement according to one of the preceding claims, **characterized in that** at least one optical unit (1) with a transmission component (3) and an optical unit (1') with a reception component (3') are arranged in a common surrounding housing (50) with two cavities (51, 52).

11. Arrangement according to Claim 10, **characterized in that** the surrounding housing (50) concomitantly surrounds the coupling part (20, 20') associated with the respective optical unit (1, 1').

12. Arrangement according to Claim 10 or 11, **characterized in that** the surrounding housing (50) comprises or has an electromagnetically shielding material.

13. Arrangement according to one of Claims 10 to 12, **characterized in that** the coupling part (20, 20'), for the two circuit carriers (2) or optical units (1, 1'), respectively is embodied in one part with regard to its mechanical structures, two partial regions connected to one another by a connecting web preferably being formed.

## Revendications

1. Dispositif optoélectronique émetteur et/ou récepteur comprenant :
- une unité (1, 1') optique ayant :
o un composant (3) émetteur et/ou un composant (3') récepteur,
o un composant (4) de montage électrique pour le composant (3) émetteur et/ou pour le composant (3') récepteur,
o un support (2) de montage, sur lequel les composants (3, 3', 4) sont montés et sont mis en contact électrique, et
- une partie (20, 20') de couplage pour la réception et le couplage d'au moins une fibre (30) optique qui peut être couplée optiquement au composant (3) émetteur et/ou au composant (3') récepteur, dans lequel la partie (20) de couplage a une grille (40) de connexion qui a des premières parties (41) de contact pour la mise en contact électrique du support (2) de montage et des deuxièmes parties (42) de contact pour la mise en contact électrique d'une platine (60) principale de montage,
**caractérisé en ce que**
- la mise en contact électrique du support (2) de montage s'effectue par la grille (40) de connexion, et
- l'unité (1, 1') optique est constituée sous la forme d'une puce pouvant être montée en surface et pouvant être mise sur la partie (20, 20') de couplage, les contacts (7) électriques de la puce étant reliés directement aux premières parties (41) de contact associées de la grille (40) de connexion.

2. Dispositif suivant la revendication 1, **caractérisé en ce que** le support (2) de montage a au moins une ouverture (9) et le composant (3) émetteur ou le composant (3') récepteur sont disposés d'un côté du support (2) de montage, de façon à ce que le trajet optique partant du composant (3, 3') émetteur et/ou récepteur et y allant s'étende, en passant par l'ouverture, vers l'autre côté arrière du support (2) de montage, le support (2) de montage étant couplé du côté arrière à la partie (20) de couplage.

3. Dispositif suivant la revendication 1 ou 2, **caractérisé en ce qu'**il est prévu des structures (23, 5) d'ajustement sur la partie (20) de couplage et sur le support (2) de montage, qui permettent d'avoir un alignement passif des parties.

4. Dispositif suivant la revendication 2 ou 3, **caractérisé en ce que**, dans l'ouverture (9) du support (2) de montage, est disposée une lentille (5) optique qui fait saillie du côté arrière du support (2) de montage et qui provoque un couplage mécanique et un ajustement du support (2) de montage avec la partie (20) de couplage.

5. Dispositif suivant l'une des revendications précédentes, **caractérisé en ce que** le support (2) de montage est constitué sous la forme d'une plaque de base segmentée, dont les segments (21, 22, 23) individuels peuvent avoir un potentiel différent.

6. Dispositif suivant la revendication 5, **caractérisé en ce que** la grille (40) de connexion de la partie de couplage est également segmentée dans la partie (41) de contact avec le support (2) de montage et a des segments (411, 412, 413) qui correspondent à ceux du support (2) de montage.

7. Dispositif suivant la revendication 6, **caractérisé en ce que** la grille (40) de connexion est en un métal relativement épais, en ayant de préférence une épaisseur supérieure ou égale à 0,2 mm, et d'une manière particulièrement préférée en ayant une épaisseur supérieure ou égale à 0,3 mm.

8. Dispositif suivant l'une des revendications précédentes, **caractérisé en ce que** la partie (20) de couplage a une structure (24) mécanique d'ancrage pour l'assemblage mécanique avec la platine (60) principale de montage.

9. Dispositif suivant l'une des revendications précédentes, **caractérisé en ce que** la partie (20) de couplage est constituée sous la forme d'une partie pouvant être montée en surface.

10. Dispositif suivant l'une des revendications précédentes, **caractérisé en ce qu'**au moins une unité (1) optique ayant un composant (3) émetteur et une unité (1') optique ayant un élément (3') récepteur sont disposées dans un boîtier (50) commun ayant deux cavités (51, 52).

11. Dispositif suivant la revendication 10, **caractérisé en ce que** le boîtier (50) entoure la partie (20, 20') de couplage associée à l'unité (1, 1') optique respective.

12. Dispositif suivant la revendication 10 ou 11, **caractérisé en ce que** le boîtier (50) est en un matériau de blindage électromagnétique ou en comporte.

13. Dispositif suivant l'une des revendications 10 à 12, **caractérisé en ce que** la partie (20, 20') de couplage pour les deux supports (2) de montage ou unités (1, 1') optiques est réalisée, du point de vue de sa structure mécanique, en une seule pièce, en constituant de préférence deux sous-parties qui sont assemblées entre elles par une barrette de liaison.
